# EUROPEAN PATENT SPECIFICATION

(11) **EP 4 073 839 B1**
(45) Date of publication and mention of the grant of the patent: **17.07.2024**
(21) Application number: 20838764.7
(22) Date of filing: 10.12.2020
(51) Int. Cl.: H01L 25/075, H01L 33/50, H01L 33/56, H01L 33/60

(54) **LIGHT EMITTING DIODES WITH REFLECTIVE SIDEWALLS COMPRISING POROUS PARTICLES**
LEUCHTDIODEN MIT REFLEKTIERENDEN SEITENWÄNDEN MIT PORÖSEN PARTIKELN
DIODES ÉLECTROLUMINESCENTES AVEC DES PAROIS LATÉRALES RÉFLÉCHISSANTES COMPRENANT DES PARTICULES POREUSES

(30) Priority: 12.12.2019 US 201916712607
(43) Date of publication of application: 19.10.2022
(73) Proprietor: Lumileds LLC, San Jose, CA 95131 (US)
(72) Inventor: BOHMER, Marcel Rene, 5652 AB Eindhoven (NL); SHIMIZU, Kentaro, Sunnyvale, California 94087 (US)
(74) Representative: dompatent von Kreisler Selting Werner - Partnerschaft von Patent- und Rechtsanwälten mbB
(86) International application number: PCT/US2020/064318
(87) International publication number: WO 2021/119317

(56) References cited:
- EP-A1- 2 216 834
- EP-A1- 2 409 340
- EP-A1- 3 249 712
- DE-A1- 102018 106 695
- US-A1- 2011 175 117
- US-A1- 2013 049 573
- US-A1- 2016 109 099
- US-A1- 2017 133 559
- US-A1- 2019 196 069

## Description

### FIELD OF THE INVENTION

The invention relates generally to phosphor-converted light emitting diodes.

### BACKGROUND

Semiconductor light emitting diodes and laser diodes (collectively referred to herein as "LEDs") are among the most efficient light sources currently available. The emission spectrum of an LED typically exhibits a single narrow peak at a wavelength determined by the structure of the device and by the composition of the semiconductor materials from which it is constructed. By suitable choice of device structure and material system, LEDs may be designed to operate at ultraviolet, visible, or infrared wavelengths.

LEDs may be combined with one or more wavelength converting materials (generally referred to herein as "phosphors") that absorb light emitted by the LED and in response emit light of a longer wavelength. For such phosphor-converted LEDs ("pcLEDs"), the fraction of the light emitted by the LED that is absorbed by the phosphors depends on the amount of phosphor material in the optical path of the light emitted by the LED, for example on the concentration of phosphor material in a phosphor layer disposed on or around the LED and the thickness of the layer.

Phosphor-converted LEDs may be designed so that all of the light emitted by the LED is absorbed by one or more phosphors, in which case the emission from the pcLED is entirely from the phosphors. In such cases the phosphor may be selected, for example, to emit light in a narrow spectral region that is not efficiently generated directly by an LED.

Alternatively, pcLEDs may be designed so that only a portion of the light emitted by the LED is absorbed by the phosphors, in which case the emission from the pcLED is a mixture of light emitted by the LED and light emitted by the phosphors. By suitable choice of LED, phosphors, and phosphor composition, such a pcLED may be designed to emit, for example, white light having a desired color temperature and desired color-rendering properties.

Multiple LEDs or pcLEDs can be formed together on a single substrate to form an array. Such arrays can be employed to form active illuminated displays, such as those employed in, e.g., smartphones and smart watches, computer or video displays, augmented- or virtual-reality displays, or signage, or to form adaptive illumination sources, such as those employed in, e.g., automotive headlights, camera flash sources, or flashlights (i.e., torches). An array having one or several or many individual devices per millimeter (e.g., device pitch of about a millimeter, a few hundred microns, or less than 100 microns, and spacing between adjacent devices less than 100 microns or only a few tens of microns or less) typically is referred to as a miniLED array or a microLED array (alternatively, a µLED array). Such mini- or microLED arrays can in many instances also include phosphor converters as described above; such arrays can be referred to as pc-miniLED or pc-microLED arrays.

US 2017/133559 A1 discloses a lighting structure including a semiconductor light emitting device and a flat wavelength converting element attached to the semiconductor light emitting device. The flat wavelength converting element includes a wavelength converting layer for absorbing light emitted by the semiconductor light emitting device and emitting light of a different wavelength. The flat wavelength converting element further includes a transparent layer. The wavelength converting layer is formed on the transparent layer.

### SUMMARY

The invention is set out in the appended set of claims.

According to the invention, a light emitting device is disclosed as recited in claim 1.

Objects and advantages pertaining to LEDs, pcLEDs, miniLED arrays, pc-miniLED arrays, microLED arrays, and pc-microLED arrays may become apparent upon referring to the examples illustrated in the drawings and disclosed in the following written description or appended claims.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

### BRIEF DESCRIPTION OF THE DRAWINGS

Fig. 1 shows a schematic cross-sectional view of an example pcLED not falling within the scope of the invention.
Figs 2A and 2B show, respectively, cross-sectional and top schematic views of an example array of pcLEDs not falling within the scope of the invention.
Fig. 3A shows a schematic cross-sectional view of an example array of pcLEDs not falling within the scope of the invention, arranged with respect to waveguides and a projection lens. Fig. 3B shows an arrangement not falling within the scope of the invention, similar to that of Figure 3A, but without the waveguides
Fig. 4A shows a top schematic view of an example miniLED or microLED array not falling within the scope of the invention, and an enlarged section of 3x3 LEDs of the array. Fig. 4B shows a perspective view of several LEDs of an example pc-miniLED or pc-microLED array not falling within the scope of the invention, monolithically formed on a substrate. Fig. 4C is a side cross-sectional schematic diagram of an example of a close-packed array of multi-colored phosphor-converted LEDS not falling within the scope of the invention on a monolithic die and substrate.
Fig. 5A is a schematic top view of a portion of an example LED display not falling within the scope of the invention in which each display pixel is a red, green, or blue phosphor-converted LED pixel. Fig. 5B is a schematic top view of a portion of an example LED display not falling within the scope of the invention in which each display pixel includes multiple phosphor-converted LED pixels (red, green, and blue) integrated onto a single die that is bonded to a control circuit backplane.
Fig. 6A shows a schematic top view an example electronics board not falling within the scope of the invention on which an array of pcLEDs may be mounted, and Fig. 6B similarly shows an example array of pcLEDs not falling within the scope of the invention mounted on the electronic board of Fig. 6A
Figure 7A, 7B, and 7C schematically illustrate an example process flow for forming a pcLED array comprising sidewall reflectors according to the invention.
Figure 8A schematically illustrates an example sidewall reflector comprising porous light scattering particles dispersed in a binder.
Figure 8B schematically illustrates an example porous light scattering particle as may be employed in the sidewall reflector of Figure 8A.
Figure 8C schematically illustrates an example coated porous light scattering particle as may be employed in the sidewall reflector of Figure 8B

The examples depicted are shown only schematically; all features may not be shown in full detail or in proper proportion; for clarity certain features or structures may be exaggerated or diminished relative to others or omitted entirely; the drawings should not be regarded as being to scale unless explicitly indicated as being to scale. For example, individual LEDs may be exaggerated in their vertical dimensions or layer thicknesses relative to their lateral extent or relative to substrate or phosphor thicknesses. The examples shown should not be construed as limiting the scope of the present disclosure or appended claims.

### DETAILED DESCRIPTION

The following detailed description should be read with reference to the drawings, in which identical reference numbers refer to like elements throughout the different figures. The drawings, which are not necessarily to scale, depict selective examples and are not intended to limit the scope of the invention. The detailed description illustrates by way of example, not by way of limitation, the principles of the invention.

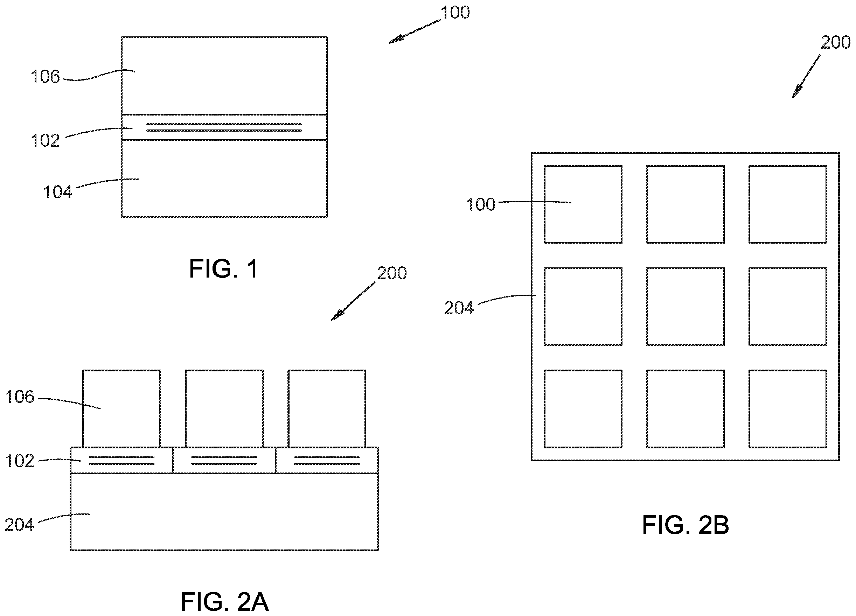

Fig. 1 shows an example not falling within the scope of the invention of an individual pcLED 100 comprising a semiconductor diode structure 102 disposed on a substrate 104, together considered herein an "LED" or "semiconductor LED", and a wavelength converting structure (e.g., phosphor layer) 106 disposed on the semiconductor LED. Semiconductor diode structure 102 typically comprises an active region disposed between n-type and p-type layers. Application of a suitable forward bias across the diode structure 102 results in emission of light from the active region. The wavelength of the emitted light is determined by the composition and structure of the active region.

The LED may be, for example, a III-Nitride LED that emits blue, violet, or ultraviolet light. LEDs formed from any other suitable material system and that emit any other suitable wavelength of light may also be used. Suitable material systems may include, for example, various III-Nitride materials, various III-Phosphide materials, various III-Arsenide materials, and various II-VI materials.

Any suitable phosphor materials may be used for or incorporated into the wavelength converting structure 106, depending on the desired optical output from the pcLED.

Figs. 2A-2B show, respectively, cross-sectional and top views of an array 200 of pcLEDs 100 not falling within the scope of the invention, each including a phosphor pixel 106, disposed on a substrate 204. Such an array may include any suitable number of pcLEDs arranged in any suitable manner. In the illustrated example the array is depicted as formed monolithically on a shared substrate, but alternatively an array of pcLEDs may be formed from separate individual pcLEDs. Substrate 204 may optionally include electrical traces or interconnects, or CMOS or other circuitry for driving the LED, and may be formed from any suitable materials.

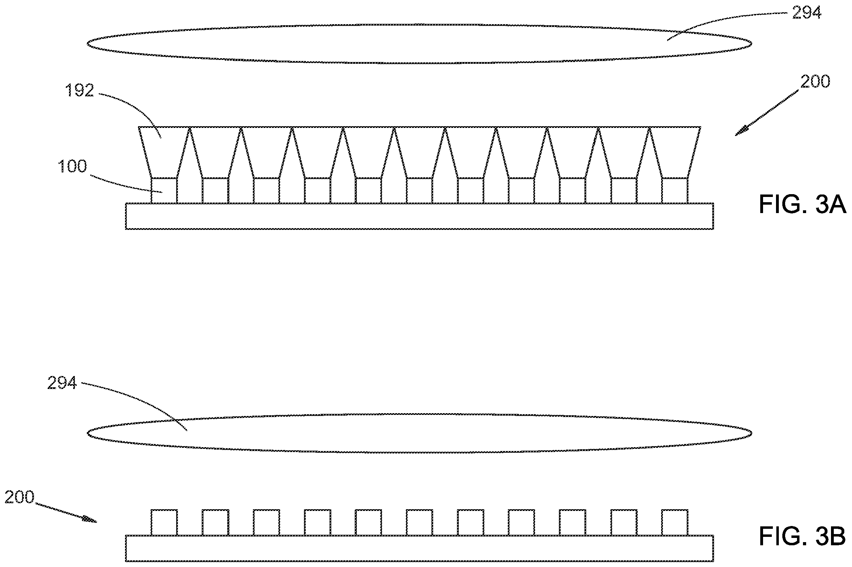

Individual pcLEDs 100 may optionally incorporate or be arranged in combination with a lens or other optical element located adjacent to or disposed on the phosphor layer. Such an optical element, not shown in the figures, may be referred to as a "primary optical element". In addition, as shown in Figures 3A and 3B, a pcLED array 200 not falling within the scope of the invention (for example, mounted on an electronics board) may be arranged in combination with secondary optical elements such as waveguides, lenses, or both for use in an intended application. In Figure 3A, light emitted by each pcLED 100 of the array 200 is collected by a corresponding waveguide 192 and directed to a projection lens 294. Projection lens 294 may be a Fresnel lens, for example. This arrangement may be suitable for use, for example, in automobile headlights. In Figure 3B, light emitted by pcLEDs of the array 200 is collected directly by projection lens 294 without use of intervening waveguides. This arrangement may particularly be suitable when pcLEDs can be spaced sufficiently close to each other, and may also be used in automobile headlights as well as in camera flash applications. A miniLED or microLED display application may use similar optical arrangements to those depicted in Figs. 3A and 3B, for example. Generally, any suitable arrangement of optical elements may be used in combination with the pcLEDs described herein, depending on the desired application.

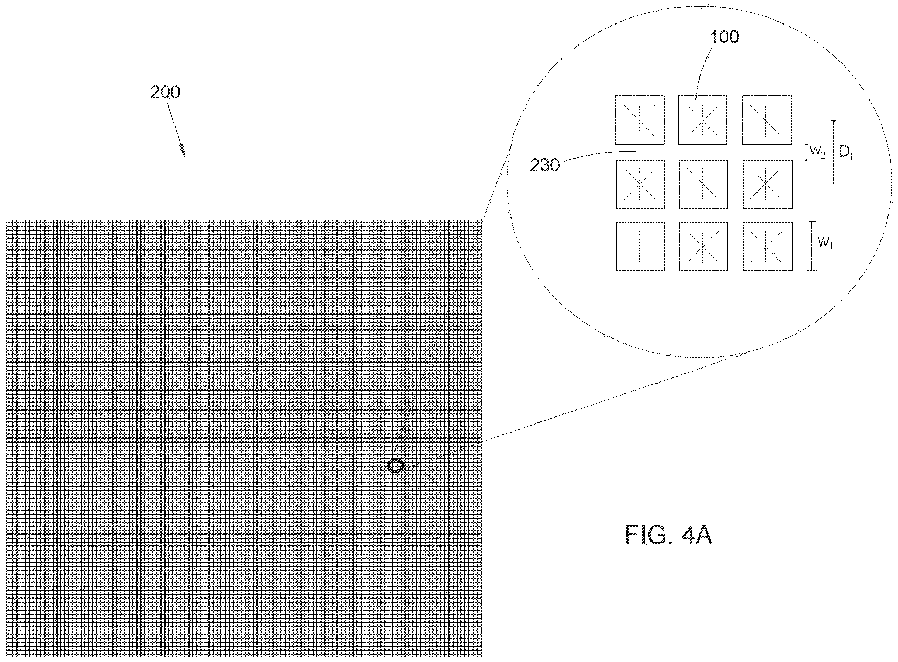

Although Figs. 2A and 2B show a 3x3 array of nine pcLEDs, such arrays may include for example on the order of 10¹, 10², 10³, 10⁴, or more LEDs, e.g., as illustrated schematically in Fig. 4A. Individual LEDs 100 (i.e., pixels) may have widths w₁ (e.g., side lengths) in the plane of the array 200, for example, less than or equal to 1 millimeter (mm), less than or equal to 500 microns, less than or equal to 100 microns, or less than or equal to 50 microns. LEDs 100 in the array 200 may be spaced apart from each other by streets, lanes, or trenches 230 having a width w₂ in the plane of the array 200 of, for example, hundreds of microns, less than or equal to 100 microns, less than or equal to 50 microns, less than or equal to 20 microns, less than or equal to 10 microns, or less than or equal to 5 microns. The pixel pitch D₁ is the sum of w₁ and w₂. Although the illustrated examples show rectangular pixels arranged in a symmetric matrix, the pixels and the array may have any suitable shape or arrangement, whether symmetric or asymmetric. Multiple separate arrays of LEDs can be combined in any suitable arrangement in any applicable format to form a larger combined array or display.

LEDs having dimensions w₁ in the plane of the array (e.g., side lengths) of less than or equal to about 0.10 millimeters microns are typically referred to as microLEDs, and an array of such microLEDs may be referred to as a microLED array. LEDs having dimensions w₁ in the plane of the array (e.g., side lengths) of between about 0.10 millimeters and about 1.0 millimeters are typically referred to as miniLEDs, and an array of such miniLEDs may be referred to as a miniLED array.

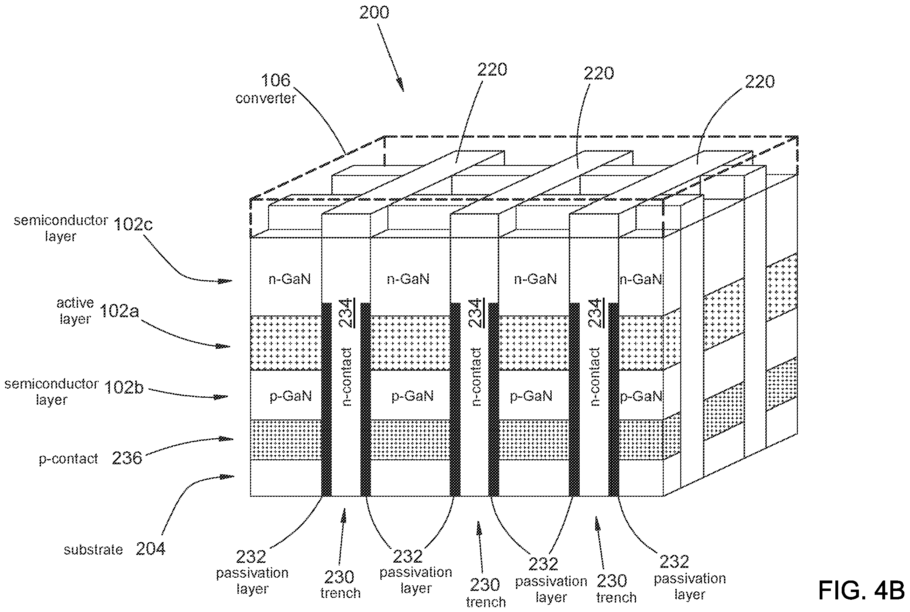

An array of LEDs, miniLEDs, or microLEDs, or portions of such an array, may be formed as a segmented monolithic structure in which individual LED pixels are electrically isolated from each other by trenches and or insulating material. Figure 4B shows a perspective view of an example of such a segmented monolithic LED array 200. Pixels in this array (i.e., individual semiconductor LED devices 102) are separated by trenches 230 which are filled to form n-contacts 234. The monolithic structure is grown or disposed on the substrate 204. Each pixel includes a p-contact 236, a p-GaN semiconductor layer 102b, an active region 102a, and an n-GaN semiconductor layer 102c; the layers 102a/102b/102c collectively form the semiconductor LED 102. A wavelength converter material 106 may be deposited on the semiconductor layer 102c (or other applicable intervening layer). Passivation layers 232 may be formed within the trenches 230 to separate at least a portion of the n-contacts 234 from one or more layers of the semiconductor. The n-contacts 234, other material within the trenches 230, or material different from material within the trenches 230 may extend into the converter material 106 to form complete or partial optical isolation barriers 220 between the pixels.

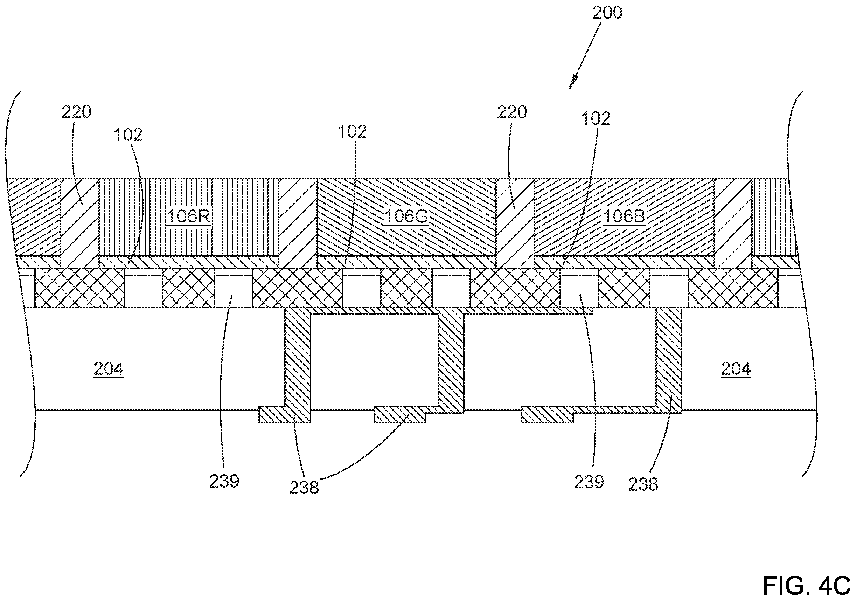

Fig. 4C is a schematic cross-sectional view of a close packed array 200 not falling within the scope of the invention of multi-colored, phosphor converted LEDs 100 on a monolithic die and substrate 204. The side view shows GaN LEDs 102 attached to the substrate 204 through metal interconnects 239 (e.g., gold-gold interconnects or solder attached to copper micropillars) and metal interconnects 238. Phosphor pixels 106 are positioned on or over corresponding GaN LED pixels 102. The semiconductor LED pixels 102 or phosphor pixels 106 (often both) can be coated on their sides with a reflective mirror or diffusive scattering layer to form an optical isolation barrier 220. In this example each phosphor pixel 106 is one of three different colors, e.g., red phosphor pixels 106R, green phosphor pixels 106G, and blue phosphor pixels 106B (still referred to generally or collectively as phosphor pixels 106). Such an arrangement can enable use of the LED array 200 as a color display.

The individual LEDs (pixels) in an LED array may be individually addressable, may be addressable as part of a group or subset of the pixels in the array, or may not be addressable. Thus, light emitting pixel arrays are useful for any application requiring or benefiting from fine-grained intensity, spatial, and temporal control of light distribution. These applications may include, but are not limited to, precise special patterning of emitted light from pixel blocks or individual pixels, in some instances including the formation of images as a display device. Depending on the application, emitted light may be spectrally distinct, adaptive over time, and/or environmentally responsive. The light emitting pixel arrays may provide preprogrammed light distribution in various intensity, spatial, or temporal patterns. The emitted light may be based at least in part on received sensor data and may be used for optical wireless communications. Associated electronics and optics may be distinct at a pixel, pixel block, or device level.

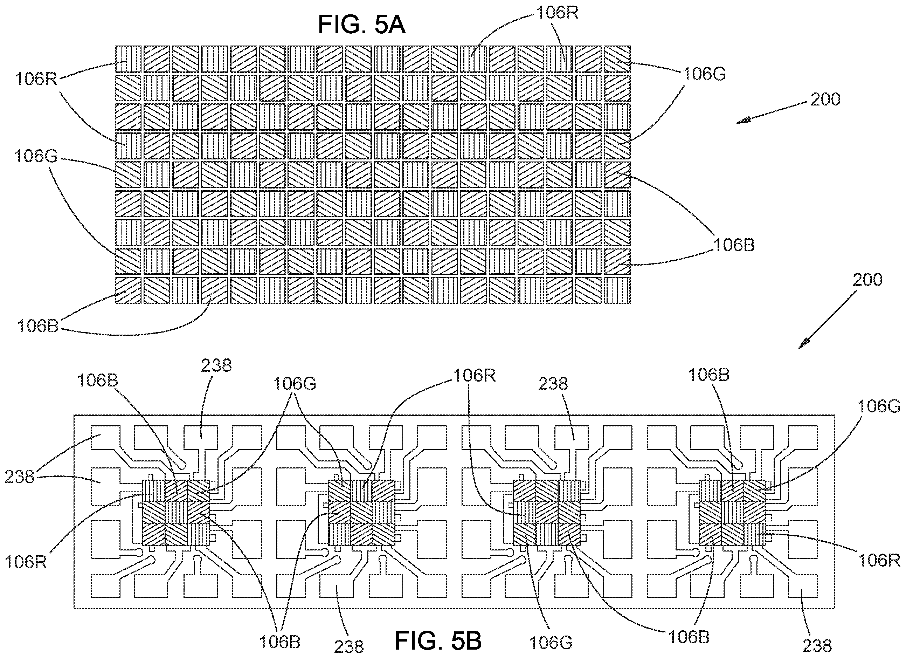

Figs. 5A and 5B are examples of LED arrays 200 not falling within the scope of the invention employed in display applications, wherein an LED display includes a multitude of display pixels. In some examples (e.g., as in Fig. 5A), each display pixel comprises a single semiconductor LED pixel 102 and a corresponding phosphor pixel 106R, 106G, or 106B of a single color (red, green, or blue). Each display pixel only provides one of the three colors. In some examples (e.g., as in Fig. 5B), each display pixel includes multiple semiconductor LED pixels 102 and multiple corresponding phosphor pixels 106 of multiple colors. In the example shown each display pixel includes a 3X3 array of semiconductor pixels 102; three of those LED pixels have red phosphor pixels 106R, three have green phosphor pixels 106G, and three have blue phosphor pixels 106B. Each display pixel can therefore produce any desired color combination. In the example shown the spatial arrangement of the different colored phosphor pixels 106 differs among the display pixels; in some examples (not shown) each display pixel can have the same arrangement of the different colored phosphor pixels 106.

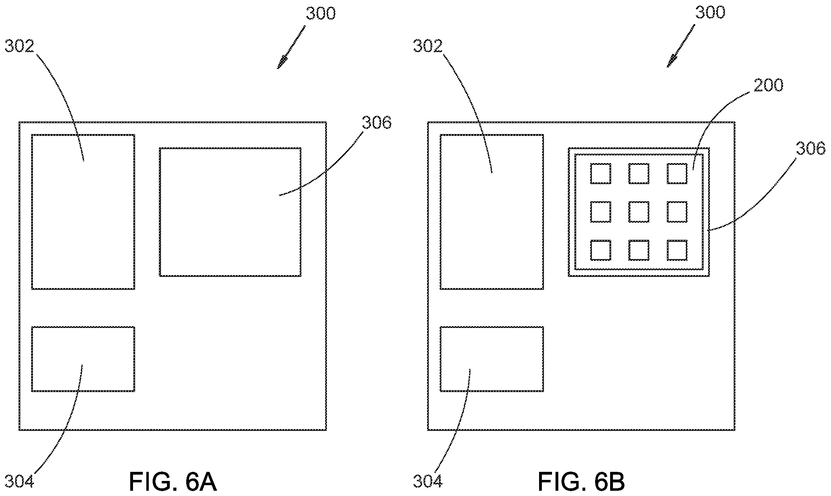

As shown in Figs. 6A and 6B, a pcLED array 200 not falling within the scope of the invention may be mounted on an electronics board 300 comprising a power and control module 302, a sensor module 304, and an LED attach region 306. Power and control module 302 may receive power and control signals from external sources and signals from sensor module 304, based on which power and control module 302 controls operation of the LEDs. Sensor module 304 may receive signals from any suitable sensors, for example from temperature or light sensors. Alternatively, pcLED array 200 may be mounted on a separate board (not shown) from the power and control module and the sensor module.

For many uses of pcLED arrays, it is desirable to compartmentalize the light emitted from the individual pcLEDs in the array. That is, it is advantageous to be able to operate an individual pcLED pixel in the array as a light source while adjacent pcLED pixels in the array remain dark. This allows for better control of displays or of illumination.

It is also advantageous in many applications to place the pcLEDs in an array close together. For example, a preferred configuration in microLEDs is to have minimal spacing between the individual LEDs. Also, closely spacing the pcLEDs in an array used as a camera flash light source or in an automobile headlight may simplify the requirements on any secondary optics and improve the illumination provided by the array.

However, if pcLEDs in an array are placed close together, optical cross talk between adjacent pcLED pixels may occur. That is, light emitted by a pcLED may scatter into or otherwise couple into an adjacent pcLED and appear to originate from that other pcLED, preventing the desired compartmentalization of light.

Conventionally, reflective sidewalls between adjacent pcLED pixels are used to reduce cross-talk. In one conventional approach, the reflective sidewalls are formed from high refractive index light scattering particles dispersed in a lower refractive index binder material. Light scattering arising from the high index contrast at the particle / binder interfaces optically isolates adjacent pixels from each other. Such conventional volume scattering approaches typically require a reflector sidewall thickness of greater than or equal to about 50 microns, for example, to provide sufficient optical isolation of adjacent pixels. The light scattering can be increased if the binder is replaced by air. However, the mechanically stability of such a system is poor and it is prone to contamination.

In another conventional approach, reflective sidewalls are formed from specularly reflective metal layers or specularly reflective stacks of dielectric layers (e.g., distributed Bragg reflectors.

In some applications, it is desirable to space pcLED pixels with a separation of less than or equal to 50. microns, less than or equal to 20 microns, less than or equal to 10 microns, or less than or equal to 4 microns. In such applications, conventional volume scattering reflective structures as described above are thicker than desirable. Further, in such applications it is difficult to form specularly reflective sidewalls due to the high aspect ratios of the channels (gaps) between adjacent pixels.

As summarized above in the "summary" section, according to the invention this specification discloses LEDs and pcLEDs having reflective sidewalls comprising porous (for example, hollow) high refractive index light scattering particles dispersed in a transparent binder material. The pores are filled with air or another gas, or are evacuated. Typically, the refractive index of the light scattering particle material is greater than or equal to about 2.0, or greater than or equal to about 2.5, the refractive index of the binder material is greater than or equal to about 1.4, and the refractive index of the (e.g., air-filled) pore is about 1.0. Light scattering in these sidewall reflectors arises mostly at the high refractive index contrast interfaces between the porous particle material and one or more voids in each particle, more than at the interface between the particle and the binder material. Because the refractive index of the pores is low (about 1.0) compared to 1.4 or more for the binder, more light scattering can be achieved with the same particle materials (in porous form) in the same binder. Alternatively, a porous particle material with a lower refractive index may be used to achieve the same amount of scattering as with conventional non-porous particle materials. Reflective sidewalls comprising such porous light scattering particles can provide desirable light confinement with thin reflector structures having, for example, a thickness of less than or equal to about 25 microns, less than or equal to about 15 microns, less than or equal to about 10 microns, or less than or equal to about 4 microns.

The porous light scattering particles may be, for example, porous Titanium Oxide (TiO₂) particles or porous Zirconium Oxide (ZrO₂) particles, but other materials may be used if suitable. The particles may have diameters (or longest dimensions) of, for example, about 0.3 microns to about 10 microns. The pores (voids) in the particles may have diameters (or longest dimensions) of, for example, about 0.10 microns to about 0.50 microns, about 0.10 microns to about 0.25 microns, about 0.20 microns to about 0.25 microns, or about 0.30 microns. Pores having a diameter of about 0.20 microns to about 0.25 microns may provide maximum scattering. In some variations, porous light scattering particles have a diameter of about 0.30 microns and each include a single closed pore having a diameter of about 0.20 microns.

The size distribution of the light scattering particles may, for example, be bimodal with a first peak at a large diameter and a second peak at a diameter of at most about 1/4 of the diameter of the first peak. This can be advantageous, with particles at the smaller of the two diameters fitting into gaps between particles of the larger of the two diameters.

Hollow particles, for instance hollow TiO₂ particles, have been used to enhance the light harvesting in photovoltaic applications (Koh et al., advanced materials 2008; Yu, J. power sources 2011; Sasanpour, J. Opt. 2011). Most experiments and theoretical studies have concentrated on particles having a single pore, but for use in sidewall reflectors as described herein it may be advantageous to form larger particles with a plurality of pores, as long as the particle size is significantly smaller than the spacing between pcLEDs. Apart from spherical particles, cylindrical hollow particles can be used to enhance the scattering effect (Sasanpour et al.).

The porous particles may include open pores, closed pores, or both open and closed pores. Open pores have a connection to the outer surface of the particle, and thus for example to the binder.

Porous particles comprising open pores may be coated with a hydrophobic material that prevents binder material from flowing into and filling or partially filling the open pores during the deposition and curing processes by which the sidewall reflectors are formed. The hydrophobic coating may coat internal surfaces defining the open pores, for example. Porous particles not comprising open pores may also be coated with a hydrophobic material to reduce sensitivity to moisture. Suitable hydrophobic materials may include, for example, silanes having hydrophobic (e.g., organic) side groups such as, for example, alkoxy-alkylsilanes, chloro-alkylsilanes, hexamethyldisilazane, and fluorinated silanes.

The transparent binder material may be for example a silicone or a sol-gel glass material.

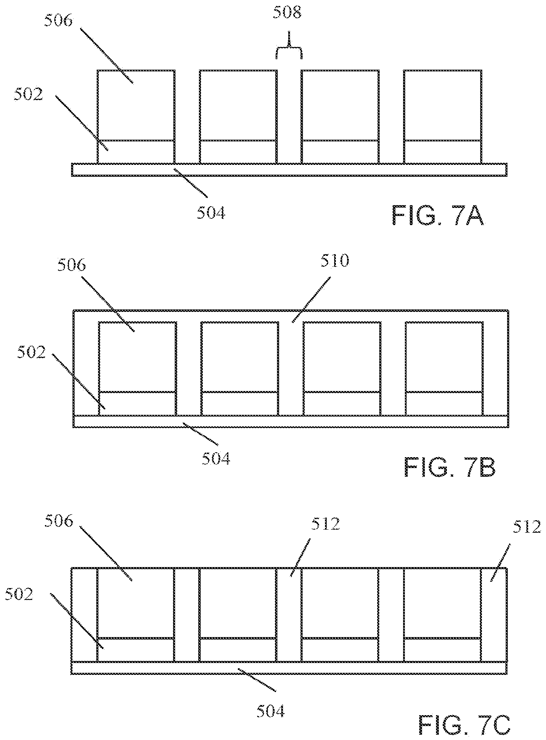

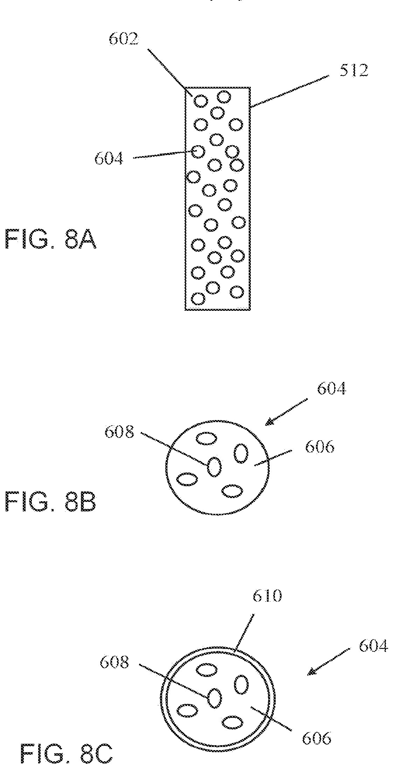

An example process flow for making a pcLED array according to the invention employing such sidewall reflectors is described next with respect to Figures 7A-7C. Any other suitable process may be used instead. Details of the example sidewall reflectors are described with respect to Figures 8A-8C.

Figure 7A schematically illustrates in a cross-sectional view a portion of an example pcLED array. In the array, semiconductor light emitting diodes 502 are mounted on a substrate 504. A wavelength converting structure 506 is located on an upper surface of each light emitting diode 502, opposite from substrate 504, to form a pcLED. The wavelength converting structures 506 may be ceramic phosphor structures, phosphor particles dispersed in a binder, or any other suitable wavelength converting structure. Adjacent pcLED pixels are separated from each other by a street (gap) having a width 508. Width 508 may be, for example, less than or equal to about 50 microns, less than or equal to about 20 microns, or less than or equal to about 10 microns, but any suitable spacing may be used.

As shown in Figure 7B a layer 510 of a light scattering composition comprising porous light scattering particles dispersed in a binder, as described above, is disposed in the streets between the pcLEDs in contact with sidewalls of the pcLEDs, and optionally over top surfaces of the pcLEDs. Layer 510 may be deposited by, for example, spin coating, spray coating, over-molding, printing, or any other suitable deposition method.

As shown in Figure 7C, any light scattering composition present on top surfaces of the pcLEDs is removed and the remaining light scattering composition is cured to form reflective sidewalls 512 extending from substrate 504 to top light emitting surfaces of the wavelength converting structures 506.

Figure 8A schematically shows detail of an example reflective sidewall reflector 512 comprising porous light scattering particles 604 dispersed in a binder 602. Figure 8B schematically shows details of an example porous light scattering particle 604, comprising one or more voids 608 in particle material 606. Figures 8C schematically shows the porous light scattering particle of Figure 8B coated with a hydrophobic coating 610 preventing binder material 602 from entering pores 608 during deposition and curing of the light scattering composition. Hydrophobic coating 610 may, for example, penetrate or partially penetrate voids 608 that open to a surface of particle 604. Coating 610 need not form a continuous physical barrier layer as schematically shown in Figure 8C.

This disclosure is illustrative and not limiting.

The following interpretations shall apply for purposes of the present disclosure and appended claims. The words "comprising," "including," "having," and variants thereof, wherever they appear, shall be construed as open ended terminology, with the same meaning as if a phrase such as "at least" were appended after each instance thereof, unless explicitly stated otherwise. The article "a" shall be interpreted as "one or more" unless "only one," "a single," or other similar limitation is stated explicitly or is implicit in the particular context; similarly, the article "the" shall be interpreted as "one or more of the" unless "only one of the," "a single one of the," or other similar limitation is stated explicitly or is implicit in the particular context. The conjunction "or" is to be construed inclusively unless: (i) it is explicitly stated otherwise, e.g., by use of "either... or," "only one of," or similar language; or (ii) two or more of the listed alternatives are understood or disclosed (implicitly or explicitly) to be incompatible or mutually exclusive within the particular context. In that latter case, "or" would be understood to encompass only those combinations involving non-mutually-exclusive alternatives. In one example, each of "a dog or a cat," "one or more of a dog or a cat," and "one or more dogs or cats" would be interpreted as one or more dogs without any cats, or one or more cats without any dogs, or one or more of each. In another example, each of "a dog, a cat, or a mouse," "one or more of a dog, a cat, or a mouse," and "one or more dogs, cats, or mice" would be interpreted as (i) one or more dogs without any cats or mice, (ii) one or more cats without and dogs or mice, (iii) one or more mice without any dogs or cats, (iv) one or more dogs and one or more cats without any mice, (v) one or more dogs and one or more mice without any cats, (vi) one or more cats and one or more mice without any dogs, or (vii) one or more dogs, one or more cats, and one or more mice. In another example, each of "two or more of a dog, a cat, or a mouse" or "two or more dogs, cats, or mice" would be interpreted as (i) one or more dogs and one or more cats without any mice, (ii) one or more dogs and one or more mice without any cats, (iii) one or more cats and one or more mice without and dogs, or (iv) one or more dogs, one or more cats, and one or more mice; "three or more," "four or more," and so on would be analogously interpreted.

For purposes of the present disclosure or appended claims, when terms are employed such as "about equal to," "substantially equal to," "greater than about," "less than about," and so forth, in relation to a numerical quantity, standard conventions pertaining to measurement precision and significant digits shall apply, unless a differing interpretation is explicitly set forth. For null quantities described by phrases such as "substantially prevented," "substantially absent," "substantially eliminated," "about equal to zero," "negligible," and so forth, each such phrase shall denote the case wherein the quantity in question has been reduced or diminished to such an extent that, for practical purposes in the context of the intended operation or use of the disclosed or claimed apparatus or method, the overall behavior or performance of the apparatus or method does not differ from that which would have occurred had the null quantity in fact been completely removed, exactly equal to zero, or otherwise exactly nulled.

For purposes of the present disclosure and appended claims, any labelling of elements, steps, limitations, or other portions of an embodiment, example, or claim (e.g., first, second, third, etc., (a), (b), (c), etc., or (i), (ii), (iii), etc.) is only for purposes of clarity, and shall not be construed as implying any sort of ordering or precedence of the portions so labelled. If any such ordering or precedence is intended, it will be explicitly recited in the embodiment, example, or claim or, in some instances, it will be implicit or inherent based on the specific content of the embodiment, example, or claim.

The invention is defined by the appended claims.

## Claims

1. A light emitting device comprising:
a plurality of phosphor converted light emitting diodes (502) disposed on a shared substrate (504) with adjacent phosphor converted light emitting diodes separated by gaps; and
a light scattering composition filling the gaps to form sidewall reflectors (512) shared by adjacent phosphor converted light emitting diodes, the sidewall reflectors reducing optical cross-talk across the gaps between the adjacent phosphor converted light emitting diodes,
**characterized by**
the light scattering composition comprising porous light scattering particles (604) dispersed in a transparent binder (602), the porous light scattering particles each including one or more pores (608) defined by inner surfaces of the porous light scattering particles.

2. The light emitting device of claim 1, wherein at least some of the porous light scattering particles include therein one or more gas-filled pores.

3. The light emitting device of any one of claims 1 to 2, wherein at least some of the porous light scattering particles include therein one or more evacuated pores.

4. The light emitting device of any one of claims 1 to 3, wherein at least some of the porous light scattering particles include therein one or more closed pores.

5. The light emitting device of any one of claims 1 to 4, wherein at least some of the porous light scattering particles include therein one or more open pores.

6. The light emitting device of any one of claims 1 to 5, wherein the porous light scattering particles have a refractive index of greater than or equal to about 2.0 and the pores have a refractive index of about 1.0.

7. The light emitting device of any one of claims 1 to 6, wherein the porous light scattering particles have transverse sizes of about 0.3 microns to about 10 microns.

8. The light emitting device of any one of claims 1 to 7, wherein the pores have transverse sizes of about 0.10 microns to about 0.50 microns.

9. The light emitting device of any one of claims 1 to 8, wherein at least some of the porous light scattering particles include a hydrophobic coating.

10. The light emitting device of claim 9, wherein the hydrophobic coating coats internal surfaces of at least some of the pores in the porous particle.

11. The light emitting device of any one of claims 1 to 10, wherein:
the gaps have a width between adjacent phosphor converted light emitting diodes of less than or equal to about 50 microns;
the porous light scattering particles have a refractive index of greater than or equal to about 2.0 and diameters of about 0.3 microns to about 10 microns;
the pores have diameters of about 0.10 microns to about 0.50 microns and a refractive index of about 1.0; and
the porous light scattering particles each comprise a hydrophobic coating.

12. The light emitting device of claim 11, wherein the gaps have a width between adjacent phosphor converted light emitting diodes of less than or equal to about 15 microns.

## Patentansprüche

1. Lichtemissionsvorrichtung mit:
mehreren phosphor-konvertierten Lichtemissionsdioden (502), die auf einem gemeinsamen Substrat (504) angeordnet sind, wobei benachbarte phosphor-konvertierte Lichtemissionsdioden durch Lücken getrennt sind, und
einer lichtstreuenden Zusammensetzung, welche die Lücken füllen, um Seitenwandreflektoren (512) zu bilden, welche von benachbarten phosphor-konvertierten Lichtemissionsdioden gemeinsam genutzt werden, wobei die Seitenwandreflektoren optisches Übersprechen über die Lücken zwischen den benachbarten phosphor-konvertierten Lichtemissionsdioden verringern,
**dadurch gekennzeichnet,**
**dass** die lichtstreuende Zusammensetzung poröse lichtstreuende Partikel (604) aufweist, die in einem transparenten Bindemittel (602) dispergiert sind, wobei die porösen lichtstreuenden Partikel jeweils eine oder mehrere Poren (608) aufweisen, welche durch Innenflächen der porösen lichtstreuenden Partikel definiert sind.

2. Lichtemissionsvorrichtung nach Anspruch 1, bei welcher zumindest einige der porösen lichtstreuenden Partikel eine oder mehrere gasgefüllte Poren aufweisen.

3. Lichtemissionsvorrichtung nach einem der Ansprüche 1 bis 2, bei welcher zumindest einige der porösen lichtstreuenden Partikel eine oder mehrere evakuierte Poren aufweisen.

4. Lichtemissionsvorrichtung nach einem der Ansprüche 1 bis 3, bei welcher zumindest einige der porösen lichtstreuenden Partikel eine oder mehrere geschlossene Poren aufweisen.

5. Lichtemissionsvorrichtung nach einem der Ansprüche 1 bis 4, bei welcher zumindest einige der porösen lichtstreuenden Partikel eine oder mehrere offene Poren aufweisen.

6. Lichtemissionsvorrichtung nach einem der Ansprüche 1 bis 5, bei welcher die porösen lichtstreuenden Partikel einen Brechungsindex größer oder gleich ungefähr 2.0 aufweisen und die Poren einen Brechungsindex von ungefähr 1.0 aufweisen.

7. Lichtemissionsvorrichtung nach einem der Ansprüche 1 bis 6, bei welcher die porösen lichtstreuenden Partikel Quergrößen von ungefähr 0.3 Mikron bis ungefähr 10 Mikron aufweisen.

8. Lichtemissionsvorrichtung nach einem der Ansprüche 1 bis 7, bei welcher die Poren Quergrößen von ungefähr 0.10 Mikron bis ungefähr 0.50 Mikron aufweisen.

9. Lichtemissionsvorrichtung nach einem der Ansprüche 1 bis 8, bei welcher zumindest einige der porösen lichtstreuenden Partikel eine hydrophobe Beschichtung aufweisen.

10. Lichtemissionsvorrichtung nach Anspruch 9, bei welcher die hydrophobe Beschichtung Innenflächen zumindest einiger der Poren in dem porösen Partikel beschichten.

11. Lichtemissionsvorrichtung nach einem der Ansprüche 1 bis 10, bei welcher:
die Lücken zwischen benachbarten phosphor-konvertierten Lichtemissionsdioden eine Breite von weniger als oder gleich ungefähr 50 Mikron aufweisen;
die porösen lichtstreuenden Partikel einen Brechungsindex größer oder gleich ungefähr 2.9 und Durchmesser von ungefähr 0.3 Mikron bis ungefähr 10 Mikron aufweisen;
die Poren Durchmesser von ungefähr 0.10 Mikron bis ungefähr 0.50 und einen Brechungsindex von ungefähr 1.0 aufweisen; und
die porösen lichtstreuenden Partikel jeweils eine hydrophobe Beschichtung aufweisen.

12. Lichtemissionsvorrichtung nach Anspruch 11, bei welcher die Lücken zwischen benachbarten phosphor-konvertierten Lichtemissionsdioden eine Breite von weniger als oder gleich ungefähr 15 Mikron aufweisen.

## Revendications

1. Dispositif électroluminescent comprenant :
une pluralité de diodes électroluminescentes converties en luminophore (502) disposées sur un substrat partagé (504) avec des diodes électroluminescentes converties en luminophore adjacentes séparées par des espaces ; et
une composition de diffusion de lumière remplissant les espaces pour former des réflecteurs de paroi latérale (512) partagés par des diodes électroluminescentes converties en luminophore adjacentes, les réflecteurs de paroi latérale réduisant la diaphonie optique à travers les espaces entre les diodes électroluminescentes converties en luminophore adjacentes, **caractérisé par**
la composition de diffusion de lumière comprenant des particules de diffusion de lumière poreuses (604) dispersées dans un liant transparent (602), les particules de diffusion de lumière poreuses comportant chacune un ou plusieurs pores (608) définis par des surfaces internes des particules de diffusion de lumière poreuses.

2. Dispositif électroluminescent selon la revendication 1, dans lequel au moins certaines des particules de diffusion de lumière poreuses comportent un ou plusieurs pores remplis de gaz.

3. Dispositif électroluminescent selon l'une quelconque des revendications 1 à 2, dans lequel au moins certaines des particules de diffusion de lumière poreuses comportent un ou plusieurs pores évacués.

4. Dispositif électroluminescent selon l'une quelconque des revendications 1 à 3, dans lequel au moins certaines des particules de diffusion de lumière poreuses comportent un ou plusieurs pores fermés.

5. Dispositif électroluminescent selon l'une quelconque des revendications 1 à 4, dans lequel au moins certaines des particules de diffusion de lumière poreuses comportent un ou plusieurs pores ouverts.

6. Dispositif électroluminescent selon l'une quelconque des revendications 1 à 5, dans lequel les particules de diffusion de lumière poreuses ont un indice de réfraction supérieur ou égal à environ 2,0 et les pores ont un indice de réfraction d'environ 1,0.

7. Dispositif électroluminescent selon l'une quelconque des revendications 1 à 6, dans lequel les particules de diffusion de lumière poreuses ont des tailles transversales d'environ 0,3 micromètre à environ 10 micromètres.

8. Dispositif électroluminescent selon l'une quelconque des revendications 1 à 7, dans lequel les pores ont des tailles transversales d'environ 0,10 micromètre à environ 0,50 micromètre.

9. Dispositif électroluminescent selon l'une quelconque des revendications 1 à 8, dans lequel au moins certaines des particules de diffusion de lumière poreuses comportent un revêtement hydrophobe.

10. Dispositif électroluminescent selon la revendication 9, dans lequel le revêtement hydrophobe revêt des surfaces internes d'au moins certains des pores dans la particule poreuse.

11. Dispositif électroluminescent selon l'une quelconque des revendications 1 à 10, dans lequel :
les espaces ont une largeur entre des diodes électroluminescentes converties en luminophore adjacentes inférieure ou égale à environ 50 micromètres ;
les particules de diffusion de lumière poreuses ont un indice de réfraction supérieur ou égal à environ 2,0 et des diamètres d'environ 0,3 micromètre à environ 10 micromètres ;
les pores ont des diamètres d'environ 0,10 micromètre à environ 0,50 micromètre et un indice de réfraction d'environ 1,0 ; et
les particules poreuses de diffusion de lumière comprennent chacune un revêtement hydrophobe.

12. Dispositif électroluminescent selon la revendication 11, dans lequel les espaces ont une largeur entre des diodes électroluminescentes converties en luminophore adjacentes inférieure ou égale à environ 15 micromètres.
